Europäisches Patentamt

European Patent Office

Office européen des brevets

(11) Publication number: **0 506 122 A2**

# EUROPEAN PATENT APPLICATION

(21) Application number: **92105378.1**

(22) Date of filing: **27.03.92**

(51) Int. Cl.5: **H01L 25/07**

(30) Priority: **29.03.91 JP 66312/91**
**29.03.91 JP 66315/91**

(43) Date of publication of application:
**30.09.92 Bulletin 92/40**

(84) Designated Contracting States:
**DE FR GB**

(71) Applicant: **MATSUSHITA ELECTRIC INDUSTRIAL CO., LTD**
**1006, Oaza Kadoma, Kadoma-shi Osaka 571(JP)**

(72) Inventor: **Ishikawa, Osamu**
**8-1-9 Minami-Kamodai, Kamo-cho Souraku-gun, Kyoto 619-11(JP)**
Inventor: **Ota, Yorito**
**1-6-4 Gakuen-Higashimachi, Nishi-ku Kobe-shi, Hyogo 651-21(JP)**
Inventor: **Maeda, Masahiro**
**1-4-40-358 Nonaka-minami, Yodogawa-ku Osaka 532(JP)**
Inventor: **Azuma, Chinatsu**
**44-19 Kamikashiwano-cho, Murasakino Kita-ku, Kyoto 603(JP)**
Inventor: **Yanagihara, Manabu**
**5-15-A-205 Niina Minoo-shi, Osaka 562(JP)**
Inventor: **Nishii, Katsunori**
**5-4-1-102 Kourigaoka Hirakata-shi, Osaka 573(JP)**

(74) Representative: **Patentanwälte Grünecker, Kinkeldey, Stockmair & Partner Maximilianstrasse 58 W-8000 München 22(DE)**

(54) **Power module.**

(57) In order to accomplish the miniaturization of a power module, the invention proposes such one which comprises a high frequency multi-stage power amplifier circuit which includes a chip part and a power amplifier semiconductor each mounted on a printed-circuit board that is firmly fixed to a heat radiation plate by fixing means like soldering, wherein there is arranged a microstrip line in an area of the printed-circuit board under a suface mounting type package in which said power amplifier semiconductor is mounted.

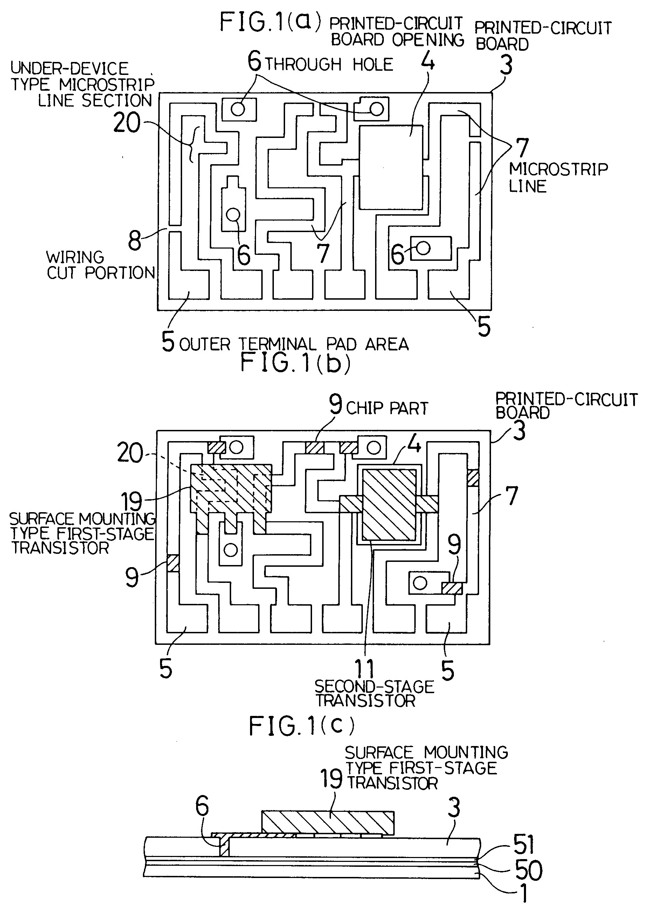

FIG.1(a) PRINTED-CIRCUIT BOARD OPENING  PRINTED-CIRCUIT BOARD

UNDER-DEVICE TYPE MICROSTRIP LINE SECTION 20
6 THROUGH HOLE 4 3
7 MICROSTRIP LINE
WIRING CUT PORTION 8 6 7 6
5 OUTER TERMINAL PAD AREA 5

FIG.1(b)
9 CHIP PART  PRINTED-CIRCUIT BOARD 3
20 4
SURFACE MOUNTING TYPE FIRST-STAGE TRANSISTOR 19 7
9 9
5 11 5
SECOND-STAGE TRANSISTOR

FIG.1(c)
SURFACE MOUNTING TYPE FIRST-STAGE TRANSISTOR 19
6 3
51
50
1

## BACKGROUND OF THE INVENTION

This invention is directed to the improvement of a power module composed of a high frequency multi-stage power amplifier circuit which includes a field effect transistor, more particularly, one with a Schottky junction (hereinafter referred to as MESFET) formed on a semiconductor GaAs substrate or a silicon bipolar transistor, and a chip part.

Power modules are used for the transmission section of a mobile communication apparatus such as a transceiver and portable telephone, and play an important role because the size and duration of message transmittable period of time of the communication apparatus depend upon its shape and performance such as efficiency. A power module is a high frequency multi-stage power amplifier circuit in which a plurality of power amplifier semiconductors and resistance and capacitance chip parts are mounted on a printed-circuit board on which a microstrip line is formed. Generally, such a printed-circuit board is soldered to a heat radiation plate of a metal to promote thermal radiation action of the power amplifier semiconductor, and the whole printed-circuit board is covered with a metal cap. The power amplifier semiconductor particularly requires heat radiation, so that it is therefore directly fixed to a metal heat radiation plate by fixing means like soldering through an opening that is formed in the printed-circuit board. However, the size of the opening thus formed in the printed-circuit board depends on the size of a package used. In addition, an area defined by the opening is not available for a microstrip line. These are difficult obstacles to accomplishing the miniaturization of a power module. A conventional power module is made up of a plurality of stages in which electric energy dealt with at amplifier stages becomes less and less as the amplifier stage moves upstream. In view of this fact, the formation of an opening in the printed-circuit board for heat radiation is less required with respect to the upstream amplifier stage as compared to the downstream stage. However, there has not been a power module that incorporates the above fact into its configuration.

In a conventional power module, a built-in type isolator is added to the output at a last stage in order to prevent the oscillation of the power module caused by the change of load, and in order to lower the level of higher harmonics which are two, three, or four times higher than the fundamental wave. Against this, in order to realize a much smaller sized power module, power modules excluding a built-in isolator have been used increasingly. The great difficulties existed in such a power module without a built-in isolator is in what way the improvement of stability against the change of load and the decrease of higher harmonics are accomplished. In fact, to achieve these objects, it is required that an isolator be included in a power module, but the inclusion of an isolator inevitably makes the power module larger.

Additionally, in the case of conventional power modules, the whole surface of a microstrip line that is formed on a printed-circuit board is covered with a resist coating having an electrically insulating effect, and an opening is formed through such a resist coating for a chip part and a transistor lead only for the purposes of soldering. However, when taking the variations in characteristics of the chip part and the transistor into account, it is necessary to adjust the different characteristics by controlling the length of the microstrip line. In a conventional power module, it is, however, almost impossible to adjust the length of the microstrip line because of the fact that the whole surface of the microstrip line is covered with a resist coating.

Further, since conventional power modules are incorporated into a rather small mobile communication apparatus, it is necessary to make a power module itself as small as possible, and to reduce the number of bias power sources from the outside as little as possible in order to accomplish the miniaturization and provide an easy-to-handle communication apparatus. According to the conventional power modules, however, a gate or base bias, and a drain or collector bias are individually supplied to a plurality of amplifier stages, which increases the number of bias supply terminals. This is an obstacle to the miniaturization. If the number of bias supply terminals is great, a greater pad area for mounting on a printed-circuit board an electrode leading terminal is required. This means that a certain area of the printed-circuit board cannot be used for forming a microstrip line or the like. Thus, the size of a power module inevitably becomes large-sized.

If a high frequency output of a power module is 1 watt, a heavy current (i.e., approximately 300 mA to 600 mA) is required as a drain current of MESFETs during operation. A typical microstrip line, which supplies such a d.c. current on the printed-circuit board used for the power module, has a line width of about 0.2 mm to 0.5 mm, and also is provided with a length of about a quarter of the wavelength of a high frequency used. However, the line width is narrow, the length is lengthy (i.e., 20 mm or thereabouts), and the heavy current flows, so that a voltage drop of the line due to resistance cannot be negligible. Also, there arises a problem that a d.c. current voltage actually supplied to the drain electrode of a MESFET declines, as compared with a direct current voltage at the bias terminal of a power module. A fixed high frequency output cannot be obtained.

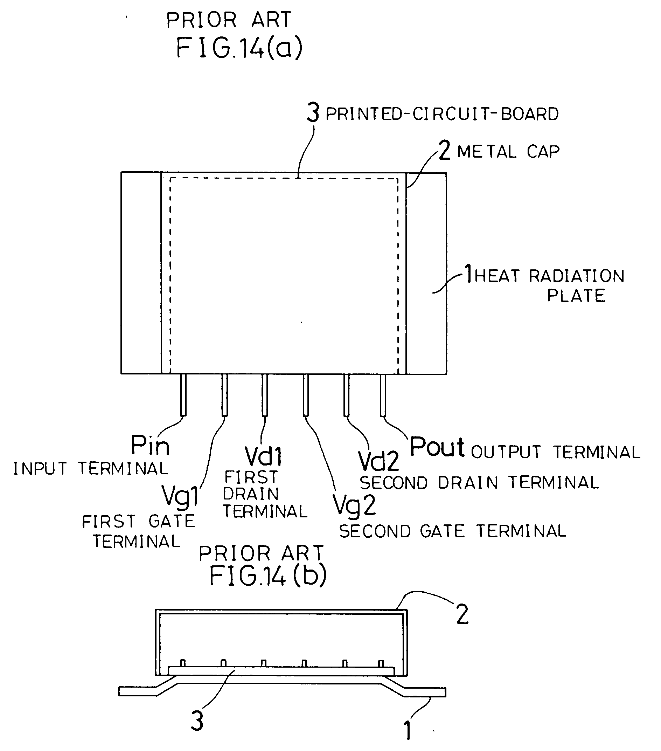

Reference is now made to Figure 14 which is an outside drawing illustrating a conventional two-stage power module that includes two MESFETs. In Figure 14(a), a printed-circuit board 3 having thereon a high frequency amplifier circuit is firmly fixed to a heat radiation plate 1 by soldering. Mounted to the printed-circuit board 3 are a first gate terminal Vg1 and a first drain terminal Vd1 in order to supply a d.c. bias to a transistor in a first-stage amplifier circuit. Also, there are provided a second gate terminal Vg2 and a second drain Vd2 in order to supply a d.c. bias to a transistor of a second-stage amplifier circuit on the printed-circuit board 3. Further, on the printed-circuit board, individual lead terminals of an input terminal Pin and an output terminal Pout of a high frequency power are provided. All of the above terminals are to be connected to the outer circuitry. As is seen from Figure 14(b), the printed-circuit board 3 is covered with a metal cap 2 so that unnecessary radiation is prevented. The conventional power module of Figure 14 takes the form of a two-stage high frequency amplifier circuit that includes a chip part, a power amplifier MESFET, and a lead terminal all mounted in the printed-circuit board 3.

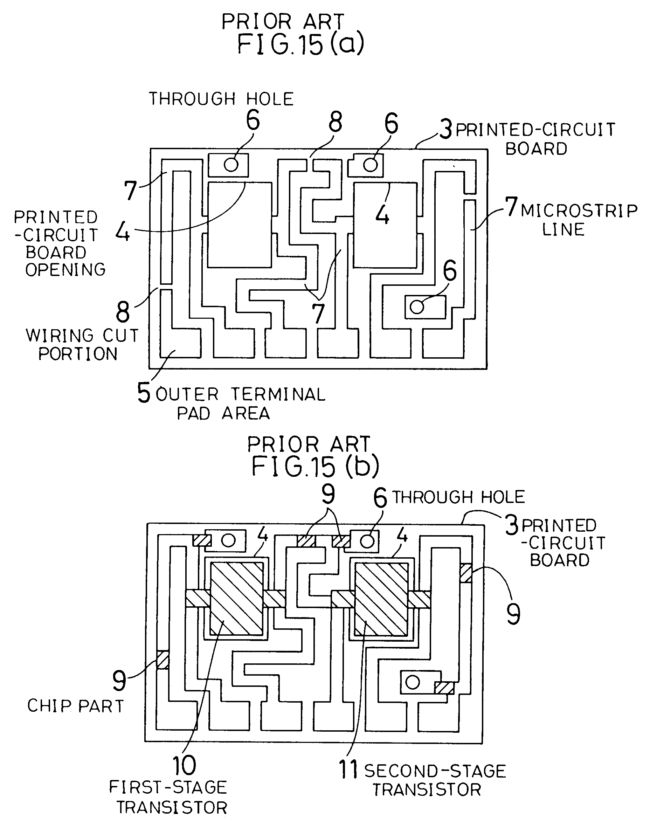

Figure 15 shows a printed-circuit board of a high frequency power amplifier circuit utilized for the conventional power module of Figure 14. Figure 15(a) shows the printed-circuit board 3 prior to the mounting of related parts, and Figure 15(b), on the other hand, shows the same printed-circuit board 3, but with the related parts including a chip part and a transistor mounted thereon. As shown in Figure 15(a), defined in the printed-circuit board 3 are two printed-circuit board openings 4 into which a transistor is inserted. On the printed-circuit board 3, there is provided a pattern for an outer terminal pad area 5 to which the lead terminal is connected. A number of through holes 6, which are electrically connected to ground of the underside of the printed-circuit board 3, are formed in the printed-circuit board 3. The chip part or some other part is connected through the through hole 6 to a ground of the underside. A microstrip line 7 is arranged almost all over the printed-circuit board 3, and is used for, such as, the conversion of impedance. The microstrip line 7 is provided with a wiring cut portion 8 to which the chip part is disposed in series. Reference is again made to Figure 15(b) which shows the printed-circuit board 3 with the chip parts and the power amplifier semiconductors mounted thereon. Inserted into the printed-circuit board openings 4 are a first-stage transistor 10 and a second-stage transistor 11. These transistors 10 and 11 are firmly fixed to the heat radiation plate 1 (not shown in Figure 15) that is disposed under the printed-circuit board 3, by means of fixing means like soldering. The chip part is soldered between ground areas emerged up to the surface of the printed-circuit board 3 by way of the wiring cut portion 8 of the microstrip line 7 and the through holes 6. With the conventional power module as shown in Figure 15, the first-stage and second-stage transistors 10 and 11 are directly soldered to the heat radiation plate 1, which necessitates forming the printed-circuit board opening 4 in the printed-circuit board 3. It is therefore not possible to arrange the microstrip line 7 on an area defined by the printed-circuit board opening 4, as a result of which the power module becomes larger by the area occupied by the opening 4. Accordingly, the formation of the opening 4 on the printed-circuit board 3 is a serious obstacle to achieving the miniaturization of a power module.

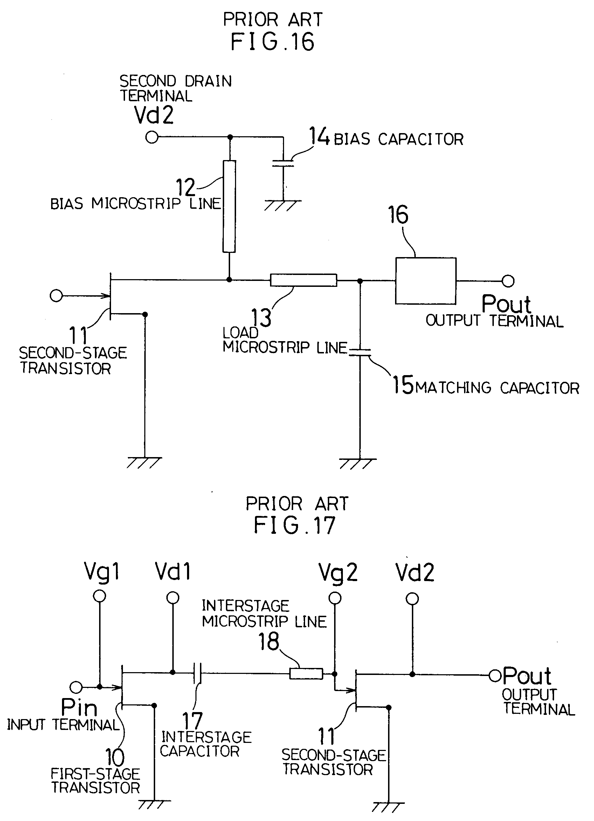

Figure 16 shows an internal configuration of a last stage of a conventional power module with an isolator at its output terminal. Although Figure 16 does not show the first-stage transistor, there is positioned an amplifier circuit in front of the second-stage transistor 11. In the conventional power module as shown in Figure 16, a d.c. bias is fed to the drain of the second-stage transistor 11 from the second drain terminal Vd2 through a bias microstrip line 12. A bias capacitor 14 is used, the value of which is about 1000pF. The bias capacitor 14 plays a role to prevent a high frequency leakage to the power source. Added to the drain of the second-stage transistor 11 is an impedance matching circuit that is made up of a load microstrip line 13 and a matching capacitor 15. Behind the matching capacitor 15 is an isolator 16 that is connected to the output terminal Pout. The isolator 16 regulates the flow of high frequency power in one direction, and, at the same time, decreases higher harmonics of a fundamental wave. Therefore, even though a reflected wave from the output terminal Pout occurs, the second-stage transistor 11 is not influenced. As a result of this, the following advantages are obtained. First, there are caused no distortions to the fundamental wave. And, the second-stage transistor 11 stably operates without generating any oscillation even if the load connected to the output terminal Pout varies greatly. Next, the amount of higher harmonic components emitted from the output terminal Pout decreases so that the jamming with respect to other communication is remarkably limited. Contrary to these advantageous aspects of the conventional power module, the isolator 16 is rather bulky for a single part, for it employs a dielectric. This is also a serious obstacle to the miniaturization of a power module.

Figure 17 is a circuit diagram showing an internal configuration of a conventional power module. In the conventional circuit as shown in the Figure 17, an interstage capacitor 17 is inserted in series between the first-stage and second-stage transistors 10 and 11 so as to separate a d.c. voltage that is applied to the drain of the first-stage transistor 10 from a d.c. voltage that is applied to the gate of the second-stage transistor 11. Also, arranged between the transistors 10 and 11 is an interstage microstrip line 18 which performs impedance matching between the output impedance of the first-stage transistor 10 and the input impedance of the second-stage transistor 11 so as to smoothly transmit electric power to the second-stage transistor 11. In the conventional configuration as shown in Figure 17, an interstage circuit between the first-stage and second-stage transistors 10 and 11 is made up of the capacitor 17 and the microstrip line 18 only. Therefore, in the event that the load that is to be connected to the output terminal Pout is much far from 50 ohms, the load of the first-stage transistor 10 varies greatly as well, the power reflection between the stages becomes greater, and finally the first-stage transistor 10 oscillates. The oscillation is generated by the following factors. First, a gain of the first-stage transistor 10 whose output power is small is greater than that of the second-stage transistor 11. Secondarily, an oscillation area with respect to load impedance is large.

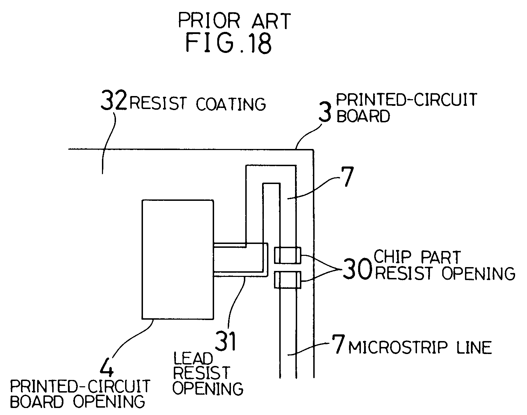

Reference is made to Figure 18 which depicts a form of a resist coating that is applied to a printed-circuit board used for a conventional power module. In the power module of Figure 18, a resist coating 32 having an electrical insulating effect is applied all over the surface of the printed-circuit board 3 and the microstrip line 7 which is formed on the printed-circuit board 3, wherein only a chip part resist opening 30 and a transistor lead resist opening 31 are provided in the resist coating 32 for the purposes of soldering. However, when taking the variations in characteristics of the chip part and the transistor into account, it is necessary to adjust the different characteristics by controlling the length of the microstrip line. In a conventional power module, however, it is almost impossible to adjust the length of the microstrip line because of the fact that the nearly whole surface of the microstrip lien 7 is covered with the resist coating 32.

The conventional module as shown in Figure 14 is a high frequency amplifier circuit having a two-stage configuration in which it is necessary to apply a d.c bias to the gate and drain of each of the first-stage and second-stage MESFETs. This requires four d.c. biases altogether, accordingly. As the number of bias supply terminals increases, a greater pad area for mounting an electrode leading terminal on the printed-circuit board is needed. Therefore, a certain area of the printed-circuit board is not available for a microstrip line or the like. As a result, the miniaturization of a power module simply cannot be achieved.

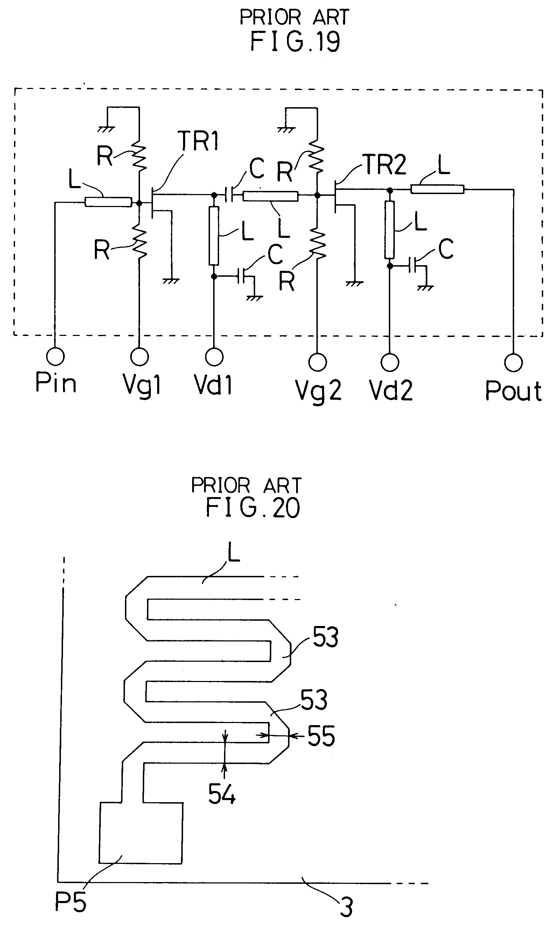

Figure 19 shows an internal circuit of a high frequency power amplifier circuit of the conventional power module of Figure 14. In Figure 19, the same reference numerals are used regarding the same elements as in Figure 14. The internal circuit comprises a first transistor TR1 as a first-stage MESFET, a second transistor TR2 as a second-stage MESFET, a resistance chip R, a capacitance chip C, and a microstrip line L that is formed on the printed-circuit board. Each gate bias is fed by way of the resistance chip R. A drain bias is fed through the microstrip line L to the transistor. For the purposes of matching the input and output impedance of each transistor, and of preventing the leakage of high frequency to a bias circuit, the microstrip line L that is formed on the printed-circuit board is given a fixed line width and length. In the conventional power module as shown in Figure 19, the first transistor TR1 (as a first-stage MESFET) and the second transistor TR2 (as a second-stage MESFET) require a direct current at their respective gates and drains. In other words, four d.c. biases are needed, which limits the miniaturization of a power module, and leads to an awkward configuration.

Figure 20 shows a bias supply area which includes a microstrip line used for the printed-circuit board of a conventional power module. Particularly, the bias supply area (a drain in the case of MESFETs) on the output side of the transistor generally uses a microstrip line with a line width of about 0.2 mm to 0.5 mm and a line length of about a quarter of the wavelength of a high frequency wave used, for supplying. Accordingly, a voltage drop at the microstrip line of the bias supply area cannot be negligible. In Figure 20, a bias pad P5, to which an outer leading terminal is soldered, is disposed on the printed-circuit board 3. Also, on the printed-circuit board 3, the microstrip line L is disposed so that it has a fixed length for feeding a bias to the output side of, such as, the transistor drain. Since it is necessary to array a lengthy microstrip line within a limited area, there has been adopted a known method for gaining the length of the microstrip line by repeatedly forming a turning area of 180 degrees, as in the case of a microstrip line turning area 53. However, in a conventional embodiment as shown in Figure 20, a straight line width 54 and a turning line width 55 are so formed that they have the same line width, so that the corner of the microstrip line turning area 53 is formed with a 45 degree pattern. Therefore, the line width of the microstrip line becomes narrower at the corner of the microstrip line turning area 53, as a result of which a considerable voltage drop takes place, a fixed voltage is not applied to the output section of a transistor, and then an output power is reduced. These drawbacks appear more conspicuously as a current that flows through the microstrip line (as a bias feeding line) becomes great, and as the number of microstrip line turning areas 53 increases.

In a conventional power module as shown in Figure 15, the first-stage and second-stage transistors 10 and 11 have a form that requires a direct soldering to the heat radiation plate, which necessitates the provision of the printed-circuit board opening 4 on the printed-circuit board 3. With such a configuration, the area, occupied by the printed-circuit board opening 4 over the whole printed-circuit board area of the power module, is large, the areas for arranging elements including the microstrip line 7 are reduced to a greater extent, and the size of the power module inevitably becomes larger. It is therefore not possible to accomplish the miniaturization with respect to a power module.

As shown in Figure 16, the isolator 16 uses a dielectric that is rather large for a single part. Accordingly, to incorporate the isolator 16 into a power module has been a serious obstacle to its miniaturization.

As is seen from the Figure 17, the interstage circuit between the first-stage and second-stage transistors 10 and 11 comprises only the capacitor 17 and the microstrip line 18, so that in the event that the load that is to be connected to the output terminal Pout is much far from 50 ohms, the load of the first-stage transistor 10 varies greatly, then, the power reflection between the transistors becomes greater, and finally the oscillation of the first-stage transistor 10 occurs.

In addition to the above, in the conventional power module as shown in Figure 18, it is almost impossible to adjust the characteristics by controlling the length of the microstrip line because the whole surface of the microstrip line 7 as well as the printed-circuit board 3 is covered with the resist coating 32.

Further, in the conventional power modules as shown in Figures 14 and 19, a gate or base bias, and a drain or collector bias are supplied to each of a plurality of amplifier stages. Therefore, many a bias supply terminal is required, the number of bias power sources provided from the outside increases so that the configuration becomes complicated. Also, a greater pad area, used for mounting an outer electrode leading terminal on the printed-circuit board, is required. This means that a certain area of the printed-circuit board cannot be used for forming a microstrip line or the like. Thus, this is not suitable for and does not contribute to the miniaturization of a power module.

As shown in Figure 20, a heavy current flows through the microstrip line as a bias supply line employed for the printed-circuit board of the conventional power module, so that a voltage drop due to resistance cannot be negligible. In addition, there arises a problem that a d.c. voltage actually supplied to the drain electrode of a MESFET declines, as compared with a d.c. voltage at the bias supply terminal of a power module. As a result, a fixed high frequency output cannot be obtained.

DISCLOSURE OF THE INVENTION

It is therefore an object of the present invention to achieve the miniaturization of a power module, and to stabilize and control the characteristics of the power module, ensuring at the same time the miniaturization thereof.

To achieve the above objects, the present invention provide a configuration that in a high frequency multi-stage power amplifier circuit which includes chip parts and power amplifier semiconductors mounted on a printed-circuit board that is firmly fixed to a heat radiation plate by fixing means like soldering, there is arranged a microstrip line in an area of the printed-circuit board under a surface mounting type package in which the power amplifier semiconductor is mounted.

Further, the invention provides a configuration that in a high frequency multi-stage power amplifier circuit which includes chip parts and power amplifier semiconductors mounted on a printed-circuit board that is firmly fixed to a heat radiation plate by fixing means like soldering, a higher harmonic series resonance circuit made up of a microstrip line and a capacitance chip part is configured in parallel with a last-stage load circuit.

Still, the invention provides a configuration that in a high frequency multi-stage power amplifier circuit which includes chip parts and power amplifier semiconductors mounted on a printed-circuit board that is firmly fixed to a heat radiation plate by fixing means like soldering, a plurality of higher harmonic series resonance circuits each made up of a microstrip line and a capacitance chip part are connected in parallel with a last-stage load circuit.

Further, the invention provides a configuration that in a high frequency multi-stage power amplifier circuit which includes chip parts and power amplifier semiconductors mounted on a printed-circuit board that is firmly fixed to a heat radiation plate by fixing means like soldering, a last-stage output bias circuit and a higher harmonic series resonance circuit made up of a microstrip line and a capacitance chip part are shared.

Still further, in order to solve the aforesaid problems, the invention provides such a configuration that in a high frequency multi-stage power amplifier circuit which includes chip parts and power amplifier semiconductors mounted on a printed-circuit board that is firmly fixed to a heat radiation plate by fixing means like soldering, a resistor is inserted between amplifier stages in series.

The invention provides a configuration that in a high frequency multi-stage power amplifier circuit which includes chip parts and power amplifier semiconductors mounted on a printed-circuit board that is firmly fixed to a heat radiation plate by fixing means like soldering, a resist coating having an electrical insulating effect is applied to the surfaces of a microstrip line and the printed-circuit board, and there is provided an opening or a plurality of openings in the resist coating, the opening spreading to a turning area or a plurality of turning areas of the microstrip line formed by turning it and connecting the opposing microstrip line portions in the vicinity of the turning area.

Additionally, in order to solve the above-described problems, the present invention proposes a configuration that in a high frequency multi-stage power amplifier circuit which includes chip parts and power amplifier semiconductors mounted on a printed-circuit board that is firmly fixed to a heat radiation plate by fixing means like soldering, a resist coating having an electrical insulating effect is applied to the surfaces of a microstrip line and the printed-circuit board, and there is provided an opening or a plurality of openings in the resist coating, the opening connecting the opposing microstrip line portions in the vicinity of a turning area of the microstrip line.

Still yet, the invention provides such a configuration that in a high frequency multi-stage power amplifier circuit which includes chip parts and power amplifier semiconductors mounted on a printed-circuit board that is firmly fixed to a heat radiation plate by fixing means like soldering, gate or base bias circuits, which are common to each amplifier stage and includes a microstrip line, are connected together, and an outer leading terminal of a gate or base bias circuit is shared.

It is another object of the invention to provide a power module which comprises a high frequency multi-stage power amplifier circuit which includes chip parts and power amplifier semiconductors mounted on a printed-circuit board that is firmly fixed to a heat radiation plate by fixing means like soldering, wherein drain or collector bias circuits, which are common to each amplifier stage and includes a microstrip line, are connected together, and an outer leading terminal of a drain or collector bias circuit is shared.

Further, the invention provides a configuration that in a high frequency multi-stage power amplifier circuit which includes chip parts and power amplifier semiconductors mounted on a printed-circuit board that is firmly fixed to a heat radiation plate by fixing means like soldering, bias circuits, which are separate each other, are common to each amplifier stages and includes a microstrip line, are connected together on the surface of the printed-circuit board by means of a short cut chip part, and a wiring pattern made up of another microstrip line is passed under the short cut chip part.

Yet, the invention provides a configuration that in a high frequency multi-stage power amplifier circuit which includes chip parts and power amplifier semiconductors mounted on a printed-circuit board that is firmly fixed to a heat radiation plate by fixing means like soldering, a wiring pattern is formed on the underside of the printed-circuit board, then the underside wiring pattern is drawn out up to the surface of the printed-circuit board through a through hole defined in the printed-circuit board, and a corresponding area of the heat radiation plate to the wiring pattern formed on the underside of the printed-circuit board is removed.

Still further, the invention provides such a configuration that in a high frequency multi-stage power amplifier circuit which includes chip parts and power amplifier semiconductors mounted on a printed-circuit board that is firmly fixed to a heat radiation plate by fixing means like soldering, a wiring pattern is formed on a part of a ground area on the underside of the printed-circuit board, a resist coating having an electrical insulating effect is applied to the wiring pattern, and the underside of the printed-circuit board is firmly fixed to a metal heat radiation plate by fixing means like soldering.

Additionally, the invention provides a configuration that in a high frequency multi-stage power amplifier circuit which includes chip parts and power amplifier semiconductors mounted on a printed-circuit board that is firmly fixed to a heat radiation plate by fixing means like soldering, the line width of a 180 degree turning area of a bias circuit using a microstrip line formed on the printed-circuit board is made wider than that of a straight area.

In a high frequency multi-stage power amplifier circuit of the invention which includes chip parts and power amplifier semiconductors mounted on a printed-circuit board that is firmly fixed to a heat radiation plate by fixing means like soldering, there is arranged a microstrip line in an area of said printed-circuit board under a surface mounting type package in which said power amplifier semiconductor is mounted. Thus, an area of the printed-circuit board under the surface mounting type package is effectively utilized. The miniaturization of a power module can be accomplished, accordingly.

Further, in a high frequency multi-stage power amplifier circuit of the invention which includes chip parts and power amplifier semiconductors mounted on a printed-circuit board that is firmly fixed to a heat radiation plate by fixing means like soldering, a harmonic series resonance circuit made up of a microstrip line and a capacitance chip part is configured in parallel with a last-stage load circuit. As a result, it is possible to reduce higher harmonic components without incorporating an isolator into the power module, and at the same time the power module can be miniaturized by an area saved by excluding the isolator.

Still further, in a high frequency multi-stage power amplifier circuit according to the invention which includes chip parts and power amplifier semiconductors mounted on a printed-circuit board that is firmly fixed to a heat radiation plate by fixing means like soldering, a plurality of higer harmonic series resonance circuits each made up of a microstrip line and a capacitance chip part are connected in parallel with a last-stage load circuit. Because of this configuration, the decrease of higher harmonic components can be achieved without incorporating an isolator into the power module. And, as well as controlling and reducing independently a plurality of higher harmonics such as secondary and third higher harmonics, the power module can be made more small-sized by an area saved by excluding an isolator.

In addition, in a high frequency multi-stage power amplifier circuit of the invention which includes chip parts and power amplifier semiconductors mounted on a printed-circuit board that is firmly fixed to a heat radiation plate by fixing means like soldering, a last-stage output bias circuit, and a harmonic series resonance circuit made up of a microstrip line and a capacitance chip part are shared. Accordingly, the decrease of higher harmonic components can be achieved without incorporating an isolator into the power module, and the power module can be made more small-sized by an area saved by excluding an isolator. In addition to these, the further miniaturization of a power module can be accomplished because a part of a bias circuit is used for reducing higher harmonics.

Further, in a high frequency multi-stage power amplifier circuit in accordance with the invention which includes chip parts and power amplifier semiconductors mounted on a printed-circuit board that is firmly fixed to a heat radiation plate by fixing means like soldering, a resistor is inserted between amplifier stages in series. Thus, ensuring the miniaturization of a power module, the reflection of power as well as the variation of impedance can be held down. Also, the oscillation of the first-stage transistor can be controlled.

In a high frequency multi-stage power amplifier circuit of the invention which includes chip parts and power amplifier semiconductors mounted on a printed-circuit board that is firmly fixed to a heat radiation plate by fixing means like soldering, a resist coating having an electrical insulating effect is applied to the surfaces of a microstrip line and the printed-circuit board, there is provided an opening or openings in the resist coating, the opening spreading to a turning area or turning areas of said microstrip line formed by turning it, and connecting the opposing microstrip line portions in the vicinity of the turning area. This enables soldering all over the opening, ensuring the miniaturization of a power module. Further, the line length of the microstrip line can be shortened equivalently, and the characteristics of the circuit can be adjusted.

Yet, according to the invention, in a power module which comprises a high frequency multi-stage power amplifier circuit which includes chip parts and power amplifier semiconductors mounted on a printed-circuit board that is firmly fixed to a heat radiation plate by fixing means like soldering, gate or base bias circuits, which are common to each amplifier stage and includes a microstrip line, are connected together, and an outer leading terminal of a gate or base bias circuit is shared. Accordingly, the bias current, output electric power, efficiency of a high frequency multi-stage power amplifier circuit can be controlled by the same gate voltage. Also, a pad area on the printed-circuit board that is connected to an outer leading terminal can be omitted so that the miniaturization of a power module can be accomplished.

Still further, in a power module which comprises a high frequency multi-stage power amplifier circuit of the invention which includes chip parts and power amplifier semiconductors mounted on a printed-circuit board that is firmly fixed to a heat radiation plate by fixing means like soldering, drain or collector bias circuits, which are common to each amplifier stage and includes a microstrip line are connected together, and an outer leading terminal of a drain or collector bias circuit is shared. Accordingly, the output power of the high frequency multi-stage power amplifier circuit can be controlled by the same drain voltage. Also, a pad area on the printed-circuit board that is connected to an outer leading terminal can be omitted so that the miniaturization of a power module can be accomplished.

Further, in a power module of the invention which comprises a high frequency multi-stage power amplifier circuit which includes chip parts and power amplifier semiconductors mounted on a printed-circuit board that is firmly fixed to a heat radiation plate by fixing means like soldering, bias circuits, which are spaced each other, are common to each amplifier stage and includes a microstrip line, are connected together on the surface of said printed-circuit board by means of a short cut chip part, and a wiring pattern made up of another microstrip line is passed under the said short cut chip part. And, to interconnect common gate or drain bias supply terminals in the power module can be accomplished. Accordingly, the miniaturization of a power module can be achieved.

Further,in a power module of the invention which comprises a high frequency multi-stage power amplifier circuit which includes chip parts and power amplifier semiconductors mounted on a printed-circuit board that is firmly fixed to a heat radiation plate by fixing means like soldering, a wiring pattern is formed on the underside of the printed-circuit board, the underside wiring pattern is drawn out up to the surface of the printed-circuit board through a through hole defined in the printed-circuit board, and a corresponding part of the heat radiation plate to the wiring pattern formed on the underside of the printed-circuit board is removed. To connect common gate or drain bias supply terminals together within the power module can be accomplished. Accordingly, the miniaturization of a power module can be achieved.

According to the invention, in a power module which comprises a high frequency multi-stage power amplifier circuit which includes chip parts and power amplifier semiconductors mounted on a printed-circuit board that is firmly fixed to a heat radiation plate by fixing means like soldering, a wiring pattern is formed on a part of a ground area on the underside of the printed-circuit board, a resist coating having an electrical insulating effect is applied to the surface of the wiring pattern, and the underside of the printed-circuit board is firmly fixed to a metal heat radiation plate by fixing means like soldering. Thus, it is possible to carry out soldering with the wiring pattern, formed on the underside of the printed-circuit board, isolated electrically from the heat radiation plate. Wiring utilizing the underside of the printed-circuit board is realized so that the miniaturization can be accomplished.

Finally, according to the invention, in a power module which comprises a high frequency multistage power amplifier circuit which includes chip parts and power amplifier semiconductors mounted on a printed-circuit board that is firmly fixed to a heat radiation plate by fixing means like soldering, the line width at a 180 degree turning area of a bias circuit using a microstrip line formed on the printed-circuit board is made wider than that of a straight area. Accordingly, ensuring the miniaturization of a power module, resistance components at the 180 degree turning area can be reduced. Besides, a voltage drop of a d.c. bias voltage supplied from the outside caused by resistance of the line can be controlled so that a given voltage can be supplied to the transistor.

The foregoing objects and various features of novelty of the present invention will be apparent from the following detailed description together with the accompanying drawings.

BRIEF DESCRIPTION OF THE DRAWINGS

The accompanying drawings show preferred embodiments of the present invention wherein:

Figure 1 is a plan view showing a printed-circuit board of a high frequency power amplifier circuit used for a power module;

Figure 2 is an internal configuration diagram in which a series resonance circuit is connected at a last-stage of the power module;

Figure 3 is an internal configuration diagram in which a plurality of series resonance circuits are connected at a last-stage of the power module;

Figure 4 is an internal configuration diagram in which an output bias circuit and a series resonance circuit are shared at a last-stage of the power module;

Figure 5 is an internal configuration diagram in which a resistor is inserted between amplifying stages at a last-stage of the power module;

Figure 6 depicts a form of a resist coating which is applied over the printed-circuit board used for the power module;

Figure 7 is an internal circuit diagram of a high frequency power amplifier circuit of the power module in which an outer leading terminal of a bias circuit of a gate is shared;

Figure 8 is an internal circuit diagram of a high frequency power amplifier circuit in which an outer leading terminal of a bias circuit of a drain is shared;

Figure 9 is an internal circuit diagram of a high frequency power amplifier circuit in which an outer leading terminal of a bias circuit of a gate and an outer leading terminal of a bias circuit of a drain are shared, respectively;

Figure 10 is a view showing a connecting means for interconnecting spaced lines on the printed-circuit board within the power module, using a short-circuit chip part;

Figure 11 is a view showing a connecting means for interconnecting spaced lines on the printed-circuit board within the power module, using a wiring pattern on the underside of the printed-circuit board;

Figure 12 is a view showing a constituting manner of the underside of a printed-circuit board in the case that the interconnection of surface wiring is made by using the underside of the printed-circuit board;

Figure 13 is a view showing a bias supply area made up of a microstrip line used for a printed-circuit board of the power module;

Figure 14 is an outside view showing a two-stage power module using two conventional MESFETs;

Figure 15 is a plan view of a printed-circuit board for a high frequency power amplifier circuit used for a conventional power module;

Figure 16 is an internal configuration diagram of a last- stage of a conventional power module with an isolator at its output terminal;

Figure 17 is a circuit diagram showing an internal configuration of a conventional power module;

Figure 18 is a view showing a form of a resist film which is applied to a printed-circuit board used for a conventional power module;

Figure 19 is an internal circuit diagram for a high frequency power amplifier circuit of a conventional power module; and

Figure 20 is a view showing a bias supply area composed of a microstrip line used for a printed-circuit board of a conventional power module.

## DETAILED DESCRIPTION OF THE INVENTION

Now referring to the accompanying drawings, the preferred embodiments of the invention will be described.

Figure 1 shows a printed-circuit board of a high frequency power amplifier circuit of a power module including a surface mounting type transistor. Hereinafter, with regard to the same elements, already described in the description of the invention, as those in Figures 15, 16, 17, 18, 19, and 20, the same reference numerals will be used. Figure 1(a) shows a printed-circuit board 3 without parts mounted thereon. Figure 1(b) shows the printed-circuit board 3 with a chip part and a transistor mounted thereon. Figure 1(c) is a sectional view of the printed-circuit board around a first-stage transistor 19 of surface mounting type. In Figure 1(a), just a single printed-circuit board opening 4, into which a second-stage transistor 11 is inserted, is formed in the printed-circuit board 3. The first-stage transistor 19 is of a surface mounting type, so that there is no need to provide the printed-circuit board opening 4 for the first-stage transistor 19. The second-stage transistor 11 is a 1.5 W transistor so that its calorific value is high. Accordingly, the second-stage transistor 11 is directly soldered to a heat radiation plate through the printed-circuit board opening 4 so as to smoothly release heat generated and to effectively inhibit the rise of temperature of the second-stage transistor 11. On the other hand, the first-stage transistor 19, which is of a surface mounting type, is a 200 mW transistor so that its calorific value is low. Therefore, the first-stage transistor is not connected to a heat radiation plate at all, or is connected to a heat radiation plate 1 disposed on the underside of the printed-circuit board 3 through a single through hole 6, as shown in Figure 1(c). Formed on an area of the printed-circuit board 3 just under the first-stage transistor 19 of surface mounting type is an under-device type microstrip line section 20 , as shown in Figures 1(a) and 1(b). In other words, the microstrip line 20 is formed even on the area of the printed-circuit board 3 under the first-stage transistor 19, so that the limited area of the printed-circuit board 3 can be utilized effectively. This enables the miniaturization of a power module.

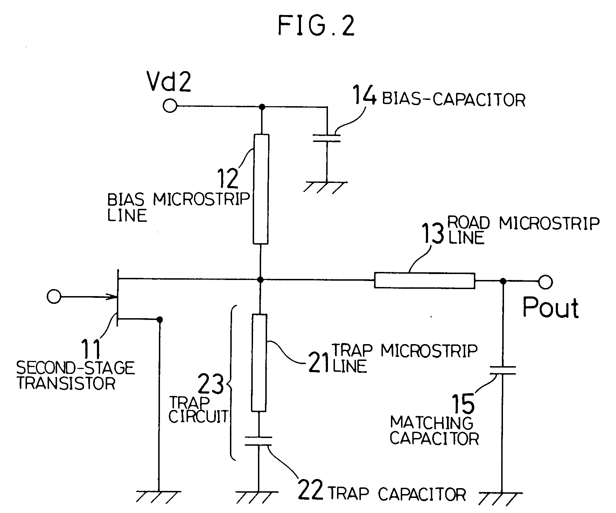

Figure 2 shows an internal configuration of a last-stage of the power module having a series resonance circuit. In Figure 2, although the first-stage transistor 11 is not shown, however, there is an amplifier circuit in front of the second-stage transistor 11. The power module as shown in Figure 2 requires no isolators. A d.c. bias is supplied from a second drain terminal Vd2 via a bias microstrip line 12 to the drain of the second-stage transistor 11. Further, added to the drain of the second-stage transistor 11 is an impedance circuit made up of a load microstrip line 13 as a matching inductance and a matching capacitor 15, being connected to an output terminal Pout. In the embodiment as shown in Figure 2, a trap circuit 23 as a higher harmonic series resonance circuit, made up of a trap microstrip line 21 and a trap capacitor 22, is formed in parallel with a last-stage load circuit in order that the higher harmonics of a fundamental wave of 0.9 GHz, for example, is reduced. To reduce the secondary higher harmonics of 1.8 GHz, the inductance L of the microstrip line 21 and the capacity C of the trap capacitor 22 are given by the following equation:

$$f = \frac{1}{2\pi\sqrt{LC}} = 1.8 \text{ GHz}.$$

Therefore, at the secondary higher harmonics of 1.8 GHz, the series impedance becomes considerably small in the trap circuit 23, and the frequency of the secondary higher harmonics as well as the output at the frequency in the vicinity thereof falls to ground, so that higher harmonic components from the output terminal can be reduced. An isolator or some other device is not required, accordingly. Thus, the miniaturization of a power module can be achieved.

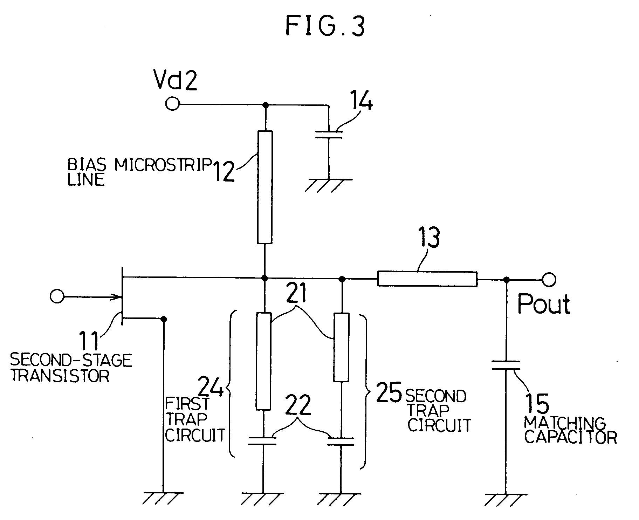

Figure 3 shows an internal configuration of a last-stage of a power module with a plurality of series resonance circuits. According to the invention as shown in Figure 3, in order to reduce the higher harmonics of a fundamental wave, a plurality of circuits of a first trap circuit 24 and a second trap circuit 25 as a higher harmonic series resonance circuit composed of the trap microstrip line 21 and the trap capacitor 22 are formed in parallel with a last-stage load circuit. The first and second trap circuits 24 and 25 series resonate at a different frequency. For example, by determining the trap microstrip line 21 and the trap capacitor 22 on the basis of the equation:

$$f = \frac{1}{2\pi\sqrt{LC}}$$

so that the first trap circuit 24 series resonates at 1.8 GHz (i.e., the secondary higher harmonics), and the second trap circuit 25 series resonates at 2.7 GHz (i.e., the third higher harmonic), it is possible to independently control and reduce higher harmonic components at a different level, and it is also possible to independently control electric power because higher harmonics is not controlled in the output load circuit. Accordingly, an isolator or the similar part is not required. Thus, the miniaturization of a power module can be achieved, and the characteristics are liable to be stable as well.

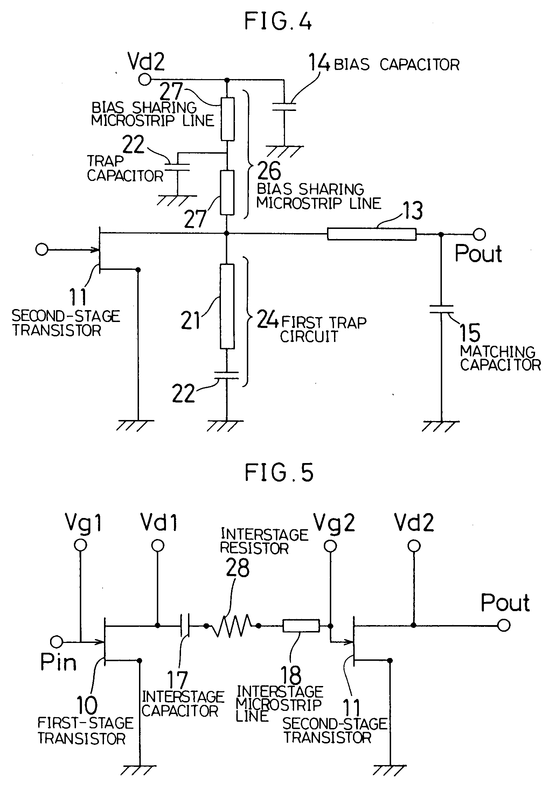

Figure 4 shows a last-stage internal configuration of a power module which shares a part of the d.c. bias circuit and a part of the series resonance circuit. In the invention as shown in Figure 4, a last-stage output bias circuit and a higher harmonic series resonance circuit are shared so as to reduce the higher harmonics of a fundamental wave, so that the higher harmonic components can be reduced without incorporating an isolator into a power module, and a limited area of the printed-circuit board can be used effectively because a part of the bias circuit is used for decreasing higher harmonics and thus an extra microstrip line as a trap circuit is not required. This enables the miniaturization of a power module, accordingly. In Figure 4, for example, the first trap circuit 24 is made to be series resonated with the secondary higher harmonics, a bias microstrip line 27 is divided into two sections, one of which being served also as a bias sharing microstrip line, the bias sharing microstrip line 27 and the trap capacitor 22 which is separately provided make up a bias sharing trap circuit 26 that is a series resonance circuits. And if individual values of the bias sharing microstrip circuit 27 and the trap capacitor 22 are determined so that the bias sharing trap circuits 26 series resonates with the third higher harmonics, it is possible to control and reduce a plurality of higher harmonics at the same time, ensuring the miniaturization of a power module. And it is obvious that the bias sharing trap circuit 26 can independently reduce a single higher harmonic.

Figure 5 is a circuit diagram showing an internal configuration of a power module wherein a resistor is inserted between two amplifier stages. In the circuit as shown in Figure 5, in order to separate a d.c. voltage applied to the drain of the first-stage transistor 10 from a d.c. voltage applied to the gate of the second-stage transistor 11, an interstage capacitor 17 and an interstage resistor 28 are inserted in series between these two transistors 10 and 11 in the circuit. The interstage 28 should be about 5 ohms to 10 ohms, within which range the power loss of a high frequency wave settles to the range from 0.1 dBm to 0.5 dBm. In an interstage circuit between the first-stage and second-stage transistors 10 and 11, as shown in Figure 5, the interstage resistor 28 is inserted in series, so that, for instance, even if the load to be connected to the output terminal Pout is much far from 50 ohms and the input impedance of the second-stage transistor 11 becomes very small, the changes of the load of the first-stage transistor 10 is limited because of the presence of the interstage resistor 28, and, further, the reflection of power occurring between the stages is reduced by the interstage resistor 28, which results that the possibility of oscillation of the first-stage transistor 10 is remarkably reduced. Accordingly, it is possible to achieve the miniaturization of a power module, and at the same time to provide a power module that is stable and free from any oscillation.

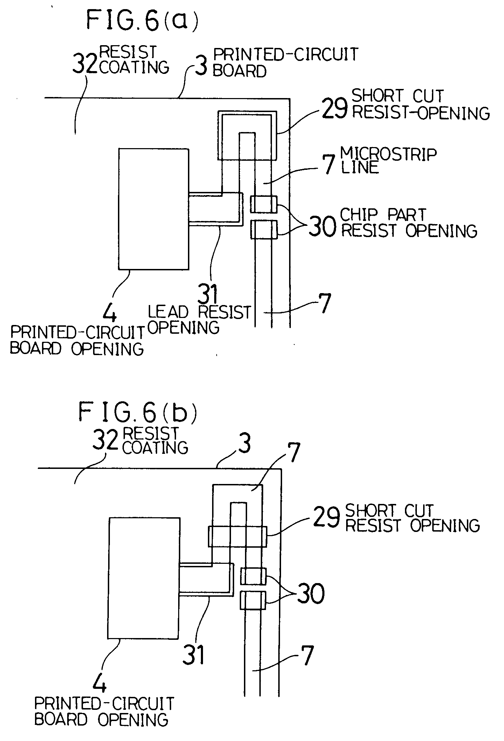

Figure 6 shows a form of a resist coating applied to a printed-circuit board used for a power module. In the power module of Figure 6, the whole microstrip line 7 formed on the printed-circuit board 3 as well as the printed-circuit board 3 is coated with a resist coating 32 having an electric insulating effect. Also formed on the microstrip line 7 and the printed-circuit board 3 are a resist opening 30 for chip parts and a resist opening 31 for transistor leads. A short cut resist opening 29 is formed in the resist coating 32 so that it spreads to the turning area of 180 degrees of the microstrip line 7, and connecting the opposing microstrip line portions in the vicinity of the turning area. Figure 6-(a) shows an embodiment in which the short cut resist opening 29 is formed on the turning area of 180 degrees of the microstrip line 7, connecting the opposing microstrip line portion in the vicinity of the turning area. Figure 6(b) shows another embodiment in which the turning area of 180 degrees of the microstrip line 7 is covered with the resist coating 32, and the short cut resist opening 29 is formed so that it connects the opposing microstrip line portions in the vicinity of the turning area. Because of this constitution, soldering can be applied to the short cut resist opening 29 formed in the resist coating 32, and the spaced microstrip line 7 can be short cut by soldering. Accordingly, it is possible to shorten the equivalent length of the microstrip line 7 without changing the arrangement of the microstrip line 7. Therefore, even when it is required to adjust the characteristics by controlling the length of the microstrip line, taking the characteristic variations of a chip part and a transistor used for a power module into account, it is possible to control the line length of the microstrip line without making a power module large-sized. However, the gap between the microstrip lines within the short cut resist opening 29 should be about 0.2 mm to 0.5 mm for connecting them by soldering.

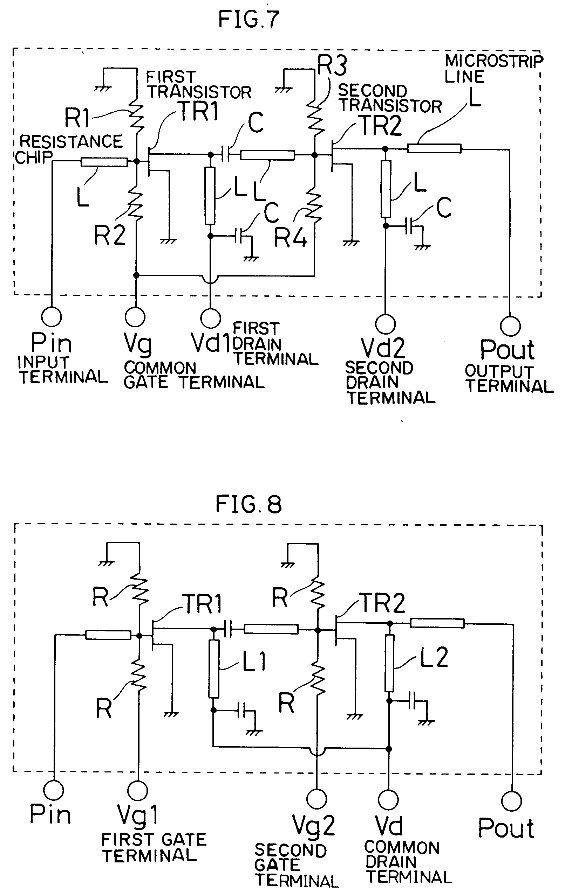

Figure 7 shows an internal circuit of a high frequency power amplifier circuit of a power module having a common gate terminal. In the invention, as shown in Figure 7, resistors R1, R2, R3 and R4 connected to the gates of a first transistor TR1 and a second transistor TR2 are interconnected in the power module, and are fed a control voltage from the outside through a common gate terminal Vg. A voltage to be applied to the gate electrode of the first transistor TR1 is regulated to a proper value by means of the two resistors R1 and R2. On the other hand, a voltage to be applied to the gate electrode of the second transistor TR2 is regulated to a proper value by means of the other two resistors R3 and R4. Accordingly, since the two transistors TR1 and TR2 can be controlled by a voltage applied to the common gate terminal Vg, it is possible to omit one pad area of the printed-circuit board for the connection of an outer leading terminal, creating an extra area for the arrangement of the microstrip line. The miniaturization of a power module is thus made possible. Further, since it is possible to control the gate potential of the multi-stage power amplifier circuit by means of a single control voltage fed to the common gate terminal Vg, there is a further advantage that the configuration of the outer circuit is simplified so that its burden is reduced. And, by employing the common gate terminal Vg, each individual bias point in the multi-stage power amplifier circuit can be at the same time separately and freely controlled to a proper voltage. Accordingly, the efficiency control range becomes extensively wide and is simplified. Although a control voltage is applied to the gate electrode of each stage of the high frequency multi-stage power amplifier circuit, it is possible to independently apply a control voltage to the drain terminal of each stage (i.e., a first drain terminal Vd1 and a second drain terminal Vd2). Accordingly, it is possible to supply a high drain voltage to a large output transistor in order to greatly increase the output. In the invention as shown in Figure 7, in order to establish the connection of the microstrip lines in the module, it is necessary to avoid any microstrip line on the printed-circuit board to be connected to the first drain terminal, for example.

Figure 8 shows an internal circuit of a high frequency power amplifier circuit of a power module having a common drain terminal. In the invention, as shown in Figure 8, microstrip lines L1 and L2 on the printed-circuit board connected to the drains of the first and second transistors TR1 and TR2 are interconnected, and are fed a single control voltage from the outside through the common gate terminal Vd. The drain potential of the first transistor TR1 A is regulated by the microstrip line L1, and the drain potential of the second transistor TR2 is regulated by the microstrip line L2. Accordingly, it is possible to omit one pad area of the printed-circuit board used for the connection of the outer leading terminal, creating an extra area for the arrangement of the microstrip line. The miniaturization of a power module is thus made possible. Further, it is possible to control each drain potential of the multi-stage power amplifier circuit by means of a voltage fed to the common drain terminal Vd. Accordingly, there is a further advantage that the configuration of the outer circuit is simplified so that its burden is reduced. And, by employing the common drain terminal Vd, each individual bias point in the multi-stage power amplifier circuit can be at the same time separately and freely controlled by means of the microstrip lines L1 and L2. Accordingly, the output control range becomes extensively wide and is simplified. In the invention as shown in Figure 8, in order to establish the connection of the microstrip lines L1 and L2 internally connected together, it is necessary to avoid any microstrip line on the printed-circuit board to be connected to the second gate terminal Vg2, for example.

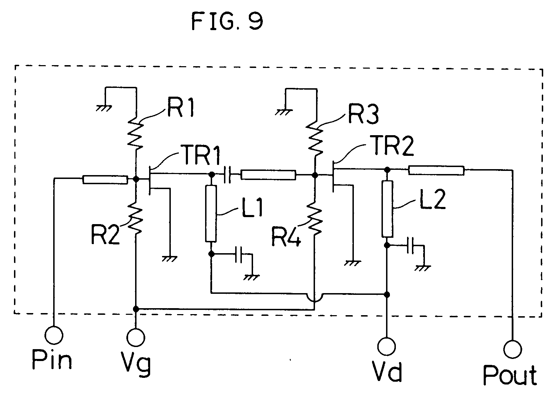

Figure 9 shows an internal circuit of a high frequency power amplifier circuit of a power module in a combination of the embodiments of Figures 7 and 8. In the embodiment according to the Figure 9, the resistors R1, R2, R3, and R4, connected to the gates of the first and second transistors TR1 and TR2, are internally connected together, and are fed a control voltage from the outside through the common gate terminal Vg. Also, the microstrip lines L1 and L2, connected to the drains of the first and second transistors TR1 and TR2, are internally connected with each other, and are fed a voltage from the outside through the common drain terminal Vd. As a result, it is possible to omit two pad areas for connecting the outer leading terminals on the printed-circuit board, and to reduce the number of outer leading terminals down to four including a single input terminal and a single output terminal. It is therefore possible to arrange an extra microstrip line in such a saved area, which further enables the miniaturization of a power module. As well as controlling the gate potential of the multi-stage power amplifier circuit by a voltage applied to the common gate terminal Vg, it is possible to control the drain potential of the multi-stage power amplifier circuit by a voltage applied to the common drain terminal Vd. Therefore, the configuration of the outer circuit can be simplified, and its burden is reduced as well. Like the foregoing embodiments, it is necessary to avoid any microstrip lines internally crossing each other on the printed-circuit board.

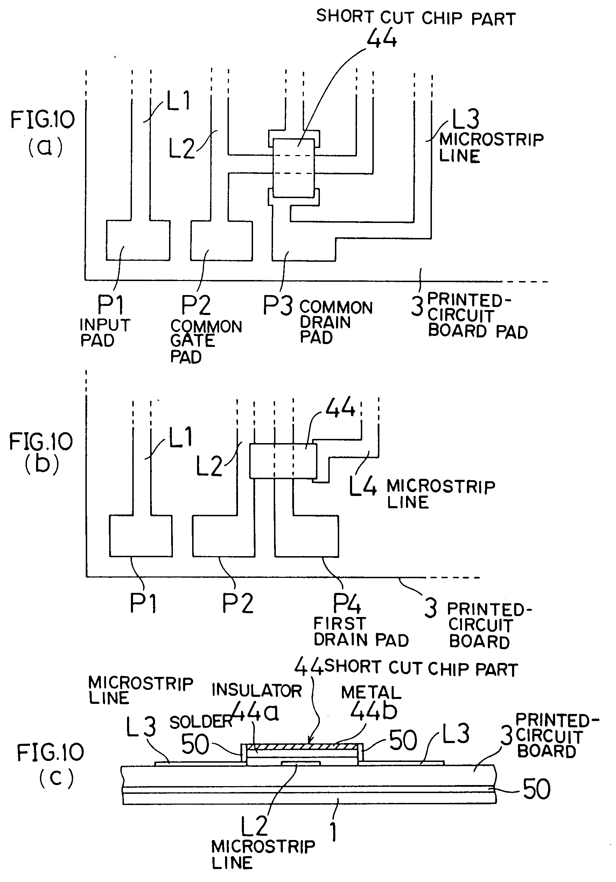

Figure 10 shows an embodiment of a power module in which microstrip lines spaced each other are connected together on the printed-circuit board in a power module by means of a short cut chip part. The printed-circuit board 3 is merged to a heat radiation plate by means like soldering, as shown in Figure 10(a). Formed on the surface of the printed-circuit board 3 are individual patterns for an input pad P1, a common gate pad P2, and a common drain pad P3 all to be connected to the outer leading terminal of the power module. From individual pads (i.e., the input pad P1, common gate pad P2, and common drain pad P3), individual microstrip lines (i.e., the microstrip lines L1, L2, and L3) are drawn out by given length and width, and are connected to the transistors of the amplifier circuit. The bias circuits including the microstrip line L2, which are spaced each other, are common to each stage and are to be connected to the common gate pad P2, are connected together. And, the bias circuits including the microstrip line L3, which are spaced each other, are common to each stage and are to be connected to the common drain pad P3, are connected with each other by means of a short cut chip part 44. As shown in Figure 10(c), the short cut chip part 44 is made up of an insulator 44a of a ceramic or the like, and a conductivity member 44b of a metal or the like applied to the upper section of the insulator 44a. With a wiring pattern made up of the other microstrip line L2 passed under the insulator 44a of the short cut chip part 44, both ends of the conductive member 44b of the short cut chip part 44 are connected to the two microstrip lines L3 common to each stage. Accordingly, the common gate bias terminals or the common drain terminals in the power module can be connected together.

Figure 10(b) shows an embodiment different from the one, as shown in Figure 10(a). Like the embodiment of Figure 10(a), in Figure 10(b), the lines are interconnected using the short cut chip part 44, however, a first drain pad P4 is used for feeding a bias to the drain of only one transistor. The common gate pad P2 is so constructed that it feeds a gate bias to a plurality of stages.

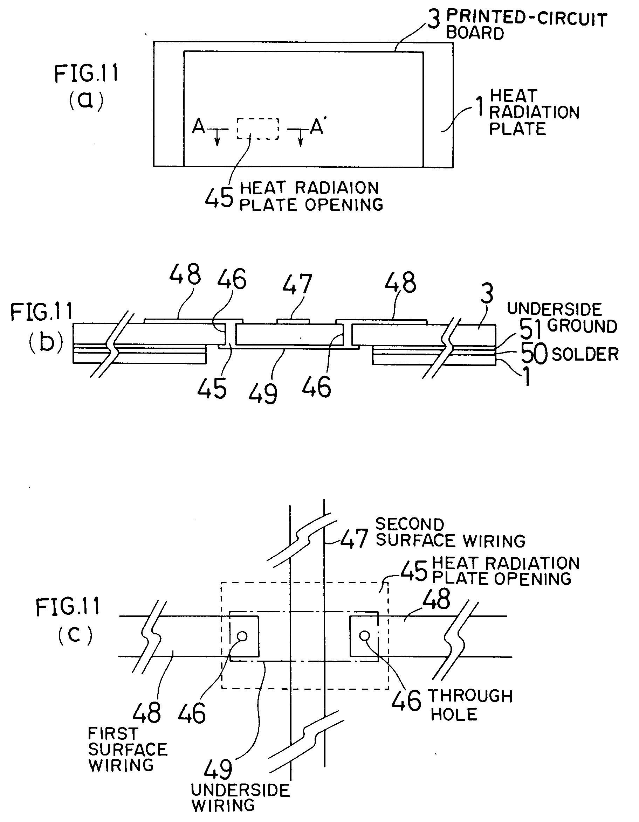

Figure 11 shows an embodiment of a power module in which lines spaced each other on a printed-circuit board are connected together using underside wiring. As shown in Figure 11(a), the printed-circuit board 3 is fixed to a heat radiation plate 1 by means like soldering. Formed on the heat radiation plate 1 is a heat radiation plate opening 45, and the heat radiation plate 1 is partly removed at a corresponding location to the heat radiation plate opening 45. The underside wiring is formed at a corresponding location of the underside of the printed-circuit board 3 to the heat radiation plate opening 45. Figure 11(b) is a sectional view taken along the line A-A' of Figure 11-(a). An underside ground 51 of the printed-circuit board 3 is soldered to the heat radiation plate 1 by a solder 50. And a first surface wiring 48 is connected to an underside wiring 49 through a through hole 46, then emerges again up the surface from the position avoiding a second surface wiring 47 through the through hole 46, and is connected to the first surface wiring 48. Figure 11(c) is an enlarged view of the heat radiation plate opening 45 of Figure 11(a). The first surface wiring 48 avoids the second surface wiring 47 via the underside wiring 49. The heat radiation plate opening 45 is formed in the underside wiring area which carries no solder.

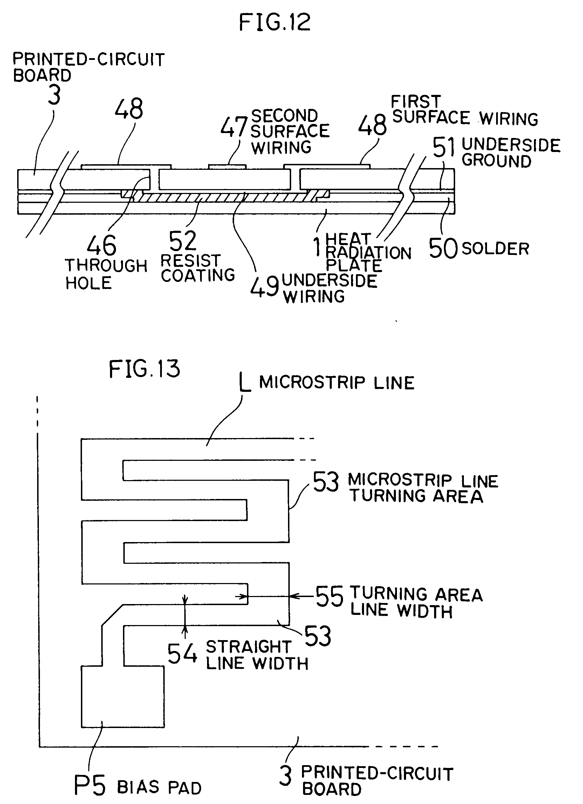

Figure 12 shows an embodiment of a power module in which the connection of the surface wiring is established by using the underside wiring of the printed-circuit board of the power module without removing part of the heat radiation plate. Similar to the embodiment of the Figure 11, the underside wiring 49 is formed on the underside of the printed-circuit board 3 through the through hole 46. However, in the invention as shown in Figure 12, there is no need to form an opening in the heat radiation plate 1 or remove part of the heat radiation plate 1. In Figure 12, there is a formation of a resist coating 52 having an electrical insulating property of 50 $\mu$m in the area of the underside wiring 49. Because of this, even in the event that the printed-circuit board 3 is entirely merged to the heat radiation plate 1, the underside wiring 49 is not electrically connected to the heat radiation plate 1. Accordingly, there is no need to form an opening in the heat radiation plate 1, so that the alignment operation for accurately aligning the heat radiation plate 1 with the opening is not necessary.

Figure 13 shows a bias supply area made up of a microstrip line used for a power module. In Figure 13, a bias pad P5, to which an outer leading terminal is soldered, is arranged on the printed-circuit board 3. Also, the microstrip line L is so formed on the printed-circuit board 3 that it extends a given length in order to supply a bias to the output side of the drain or the like of the transistor. The microstrip line L is provided with a turning area so that it changes its direction at 90 degrees, the corner of the turning area being cut out at 45 degrees in order to prevent the accumulation of capacitance, for the good transmission of higher harmonics. As shown in Figure 13, each turning area width 55 of turning areas 53, at which the microstrip line L changes its direction at 180 degrees, is made thicker than that of a straight line width 54. Since the turning area width 55 is made thicker than the straight line width 54, it is possible to reduce resistance components of the 180 degree turning area 53, to limit the voltage drop of a d.c. bias voltage that is supplied from the outside caused by the resistance of the microstrip line L, and to supply a given voltage to the transistor. Even in the event that the turning area width 55 of the turning area 53 of the microstrip line L functioning as a bias supply line is made wider than the straight line width 54, the electric length changes little, and there is little higher harmonic leakage to the microstrip line, as a bias supply line, having about a quarter length of the frequency. On the contrary, the fact that d.c. resistance components are reduced by widening the line so that the bias potential that is directly applied to the transistor is not dropped is very advantageous effects with respect to the output.

For the purposes of describing the power module of the invention, a MESFET is used as an example of transistor, however, it to be appreciated that the same effects as the MESFET are obtained by using a bipolar transistor or MOSCOW. Further, it is to be appreciated that although the examples of the two-stage high-frequency amplifier circuit are given as a power module in the specification for description purpose, the same effects as the two-stage amplifier circuit can be obtained in a multi-stage amplifier circuit not less than two-stage amplifier circuit.

## Claims

1. A power module which comprises a high frequency multi-stage power amplifier circuit which includes chip parts and power amplifier semiconductors mounted on a printed-circuit board that is firmly fixed to a heat radiation plate by fixing means like soldering, characterized in that there is arranged a microstrip line in an area of said printed-circuit board under a suface mounting type package in which said power amplifier semiconductor is mounted.

2. A power module which comprises a high frequency multi-stage power amplifier circuit which includes chip parts and power amplifier semiconductors mounted on a printed-circuit board that is firmly fixed to a heat radiation plate by fixing means like soldering, characterized in that a higher harmonic series resonance circuit made up of a microstrip line and a capacitance chip part is configured in parallel with a load circuit of a last stage.

3. A power module which comprises a high frequency multi-stage power amplifier circuit which includes chip parts and power amplifier semiconductors mounted on a printed-circuit board that is firmly fixed to a heat radiation plate by fixing means like soldering, characterized in that a plurality of higher harmonic series resonance circuits each made up of a microstrip line and a capacitance chip part are connected in parallel with a load circuit of a last output stage.

4. A power module which comprises a high frequency multi-stage power amplifier circuit which includes chip parts and power amplifier semiconductors each mounted on a printed-circuit board that is firmly fixed to a heat radiation plate by fixing means like soldering, characterized in that a last-stage output bias circuit, and a higher harmonic series resonance circuit made up of a microstrip line and a capacitance chip part are shared.

5. A power module which comprises a high frequency multi-stage power amplifier circuit which includes chip parts and power amplifier semiconductors mounted on a printed-circuit board that is firmly fixed to a heat radiation plate by fixing means like soldering, characterized in that a resistor is inserted between amplifier stages in series.

6. A power module which comprises a high frequency multi-stage power amplifier circuit which includes chip parts and power amplifier semiconductors mounted on a printed-circuit board that is firmly fixed to a heat radiation plate by fixing means like soldering wherein a resist coating having an electrical insulating effect is applied to the surfaces of a microstrip line and said printed-circuit board, characterized in that there is provided an opening or a plurality of openings in said resist coating, said opening spreading to a turning area or a plurality of turning areas of said microstrip line formed by turning it, and connecting together the opposing microstrip portions in the vicinity of said turning area.

7. A power module according to Claim 6, wherein, in a resist coating having an electrical insulating effect is applied to the surfaces of a microstrip line and said printed-circuit board, there is provided an opening or a plurality of openings in said resist coating, said opening connecting together the opposing microstrip line portions in the vicinity of a turning area formed by turning said microstrip line.

8. A power module which comprises a high frequency multi-stage power amplifier circuit which includes chip parts and power amplifier semiconductors mounted on a printed-circuit board that is firmly fixed to a heat radiation plate by fixing means like soldering, characterized in that gate or base bias circuits, which are common to each amplifier stage and includes a base microstrip line, are connected together, and an outer leading terminal of a gate or base bias circuit is shared.

9. A power module which comprises a high frequency multi-stage power amplifier circuit which includes chip parts and power amplifier semiconductors mounted on a printed-circuit board that is firmly fixed to a heat radiation plate by fixing means like soldering, characterized in that drain or collector bias circuits, which are common to each amplifier stage and includes a drain or collector microstrip line, are connected together, and an outer leading terminal of a drain or collector bias circuit is shared.

10. A power module which comprises a high frequency multi-stage power amplifier circuit which includes chip parts and power amplifier semiconductors mounted on a printed-circuit board that is firmly fixed to a heat radiation plate by fixing means like soldering, characterized in that bias circuits, which are spaced each other, are common to each amplifier stage and includes a microstrip line, are connected together on the surface of said printed-circuit board by means of a short cut chip part, and a wiring patter made up of another microstrip line is passed under the said short cut chip part.

11. A power module which comprises a high frequency multi-stage power amplifier circuit which includes chip parts and power amplifier semiconductors mounted on a printed-circuit board that is firmly fixed to a heat radiation plate by fixing means like soldering, characterized in that a wiring pattern is formed on the underside of said printed-circuit board; said underside wiring pattern is drawn out upward so that is emerges from the surface of said printed-circuit board through a through hole defined in said printed-circuit board; and a part of said heat radiation plate corresponding to said wiring pattern formed on the underside of said printed-circuit board is removed.

12. A power module which comprises a high frequency multi-stage power amplifier circuit which includes chip parts and power amplifier semiconductors each mounted on a printed-circuit board that is firmly fixed to a heat radiation plate by fixing means like soldering, characterized in that a wiring pattern is formed on a part of a ground area on the underside of said printed-circuit board, and the underside of said printed-circuit board is firmly fixed to a metal heat radiation plate by fixing means like soldering with said wiring pattern covered with a resist coating having an electrical insulating effect.

13. A power module which comprises a high frequency multi-stage power amplifier circuit which includes chip parts and power amplifier semiconductors mounted on a printed-circuit board that is firmly fixed to a heat radiation plate by fixing means like soldering, characterized in that the line width of a 180 degree turning area of a bias circuit using a microstrip line formed on said printed-circuit board is made wider than that of a straight area of said bias circuit.

FIG.1(a) PRINTED-CIRCUIT BOARD OPENING

PRINTED-CIRCUIT BOARD

6 THROUGH HOLE

4

3

UNDER-DEVICE TYPE MICROSTRIP LINE SECTION

20

7

7 MICROSTRIP LINE

8

WIRING CUT PORTION

6

7

6

5

5 OUTER TERMINAL PAD AREA

5

FIG.1(b)

9 CHIP PART

PRINTED-CIRCUIT BOARD

20

4

3

19

7

SURFACE MOUNTING TYPE FIRST-STAGE TRANSISTOR

9

9

5

9

5

11

SECOND-STAGE TRANSISTOR

FIG.1(c)

SURFACE MOUNTING TYPE FIRST-STAGE TRANSISTOR

19

6

3

51

50

1

FIG.2

# FIG.3

Vd2

14

BIAS MICROSTRIP 12
LINE

13

Pout

11
SECOND-STAGE
TRANSISTOR

21

24
FIRST
TRAP
CIRCUIT

22

25 SECOND
TRAP
CIRCUIT

15
MATCHING
CAPACITOR

## FIG.4

Vd2

14 BIAS CAPACITOR

27
BIAS SHARING
MICROSTRIP LINE

22
TRAP
CAPACITOR

26
BIAS SHARING
MICROSTRIP LINE

27

13

Pout

11
SECOND-STAGE
TRANSISTOR

21

24 FIRST TRAP
CIRCUIT

22

15
MATCHING
CAPACITOR

## FIG.5

Vg1

Vd1

INTERSTAGE
RESISTOR
28

Vg2

Vd2

Pout

Pin

10
FIRST-STAGE
TRANSISTOR

17
INTERSTAGE
CAPACITOR

18
INTERSTAGE
MICROSTRIP
LINE

11
SECOND-STAGE
TRANSISTOR

FIG.6(a)

32 RESIST COATING
3 PRINTED-CIRCUIT BOARD
29 SHORT CUT RESIST-OPENING
7 MICROSTRIP LINE
30 CHIP PART RESIST OPENING
7
31 LEAD RESIST OPENING
4 PRINTED-CIRCUIT BOARD OPENING

FIG.6(b)

32 RESIST COATING
3
7
29 SHORT CUT RESIST OPENING
30
31
7
4 PRINTED-CIRCUIT BOARD OPENING

EP 0 506 122 A2

## FIG.7

## FIG.8

20

FIG. 9

SHORT CUT CHIP PART
44

FIG.10
(a)

L1

L2

L3
MICROSTRIP
LINE

P1
INPUT
PAD

P2
COMMON
GATE
PAD

P3 COMMON
DRAIN
PAD

3 PRINTED-
CIRCUIT
BOARD PAD

FIG.10
(b)

L1

L2

44

L4 MICROSTRIP
LINE

P1

P2

P4
FIRST
DRAIN PAD

3 PRINTED-
CIRCUIT
BOARD

44 SHORT CUT CHIP PART

MICROSTRIP
LINE

INSULATOR
44a

METAL
44b

PRINTED-
CIRCUIT
BOARD

FIG.10
(c)

L3

SOLDER
50

50 L3

3

50

L2
MICROSTRIP
LINE

1

FIG.11
(a)

3 PRINTED-CIRCUIT
BOARD

1 HEAT
RADIATION
PLATE

A ↓ ─── ↓ A'

45 HEAT RADIAION
PLATE OPENING

FIG.11
(b)

48  46  47  48  3 UNDERSIDE

51 GROUND
50 SOLDER
1

45  49  46

FIG.11
(c)

47 SECOND
SURFACE WIRING

45 HEAT RADIATION
PLATE OPENING

48

46 THROUGH
HOLE

48  46

FIRST
SURFACE
WIRING

49
UNDERSIDE
WIRING

## FIG.12

PRINTED-CIRCUIT BOARD 3 / 48 / 47 SECOND SURFACE WIRING / 48 FIRST SURFACE WIRING / 51 UNDERSIDE GROUND / 46 THROUGH HOLE / 52 RESIST COATING / 49 UNDERSIDE WIRING / 1 HEAT RADIATION PLATE / 50 SOLDER

## FIG.13

L MICROSTRIP LINE / 53 MICROSTRIP LINE TURNING AREA / 55 TURNING AREA LINE WIDTH / 53 / 54 STRAIGHT LINE WIDTH / P5 BIAS PAD / 3 PRINTED-CIRCUIT BOARD

PRIOR ART
FIG.14(a)

PRIOR ART
FIG.14 (b)

PRIOR ART
FIG.15 (a)

THROUGH HOLE

6        8        6        3 PRINTED-CIRCUIT
                              BOARD

7

PRINTED
-CIRCUIT
BOARD
OPENING

4                    4        7 MICROSTRIP
                              LINE

8                              6

8

WIRING CUT
PORTION

5 OUTER TERMINAL
PAD AREA

PRIOR ART
FIG.15 (b)

9    6 THROUGH HOLE

4    9    4        3 PRINTED
                    -CIRCUIT
                    BOARD

9

9

CHIP PART

10 FIRST-STAGE
TRANSISTOR

11 SECOND-STAGE
TRANSISTOR

26

PRIOR ART
FIG.16

SECOND DRAIN
TERMINAL
Vd2

14 BIAS CAPACITOR

12

BIAS MICROSTRIP LINE

16

13

LOAD
MICROSTRIP LINE

11

SECOND-STAGE
TRANSISTOR

15 MATCHING CAPACITOR

Pout
OUTPUT TERMINAL

PRIOR ART
FIG.17

Vg1    Vd1    Vg2    Vd2

INTERSTAGE
MICROSTRIP LINE

18

Pin
INPUT TERMINAL

10

FIRST-STAGE
TRANSISTOR

17

INTERSTAGE
CAPACITOR

11

SECOND-STAGE
TRANSISTOR

Pout
OUTPUT
TERMINAL

PRIOR ART
FIG.18

32 RESIST COATING

3 PRINTED-CIRCUIT BOARD

7

30 CHIP PART RESIST OPENING

4 PRINTED-CIRCUIT BOARD OPENING

31 LEAD RESIST OPENING

7 MICROSTRIP LINE

PRIOR ART
FIG.19

Pin  Vg1  Vd1  Vg2  Vd2  Pout

PRIOR ART
FIG.20